# EUROPÄISCHE PATENTSCHRIFT

(11) **EP 3 283 321 B1**
(45) Veröffentlichungstag und Bekanntmachung des Hinweises auf die Patenterteilung: **06.03.2019**
(21) Anmeldenummer: 16717833.4
(22) Anmeldetag: 08.04.2016
(51) Int. Cl.: B60K 37/06, G06F 11/07

(54) **ERFASSEN EINER BETÄTIGUNG EINES BEDIENELEMENTS IN EINEM KRAFTFAHRZEUG**
DETECTING ACTIVATION OF AN OPERATOR CONTROL ELEMENT IN A MOTOR VEHICLE
DÉTECTION D'UN ACTIONNEMENT D'UN ÉLÉMENT DE COMMANDE DANS UN VÉHICULE AUTOMOBILE

(30) Priorität: 11.04.2015 DE 102015004694
(43) Veröffentlichungstag der Anmeldung: 21.02.2018
(73) Patentinhaber: Audi AG, 85045 Ingolstadt (DE)
(72) Erfinder: HARTMANN, Jürgen, 91468 Gutenstetten (Pahres) (DE); SASSMANNSHAUSEN, Patrick, 85113 Böhmfeld (DE)
(86) Internationale Anmeldenummer: PCT/EP2016/000579
(87) Internationale Veröffentlichungsnummer: WO 2016/165818

(56) Entgegenhaltungen:
- DE-A1-102005 039 392

## Beschreibung

Die Erfindung betrifft ein Verfahren zum Erfassen einer Betätigung eines Bedienelements in einem Kraftfahrzeug. Zu der Erfindung gehören auch ein Steuergerät sowie ein Kraftfahrzeug mit dem erfindungsgemäßen Steuergerät.

Bei dem Bedienelement kann es sich beispielsweise um einen Taster handeln. Wird ein solches Bedienelement durch einen Benutzer des Kraftfahrzeugs betätigt, so kann hierdurch eine Fahrzeugfunktion aktiviert werden, das heißt eine Aktion eingeleitet werden. Das Tastersignal wird zum Erkennen der Betätigung durch ein Steuergerät eingelesen und ausgewertet. Oftmals werden bei Bedienelementen sogenannte Masseschalter verwendet, das heißt bei Betätigen des Bedienelements wird ein Signaleingang des Steuergeräts mit einem Massepotential elektrisch verbunden oder kurz geschlossen. Wenn das Steuergerät an dem Signaleingang einen Spannungseinbruch erkennt, das heißt einen Spannungswert kleiner als ein vorbestimmter Schwellwert am Steuereingang ist, dann wird durch das Steuergerät das Bedienelement als betätigt erkannt.

Nachteilig bei dieser Betätigungserkennung ist, dass das Steuergerät auf einen stabilen zeitlichen Verlauf einer Versorgungsspannung des Steuergeräts und des Bedienelements angewiesen ist. In einem Kraftfahrzeug kann sich allerdings eine instabile Versorgungsspannung ergeben, das heißt unabhängig von einer Betätigung des Bedienelements kann die Versorgungsspannung auf einen Wert kleiner als ein vorbestimmter Nominalwert sinken, was dann auch zu einem Absinken der Spannung am Signaleingang des Steuergeräts führt. Beispielsweise kann das Abklemmen und das Anklemmen der Fahrzeugbatterie eine hohe Bordnetzwelligkeit, das heißt Spannungsschwankungen der Versorgungsspannung, verursachen. Das kann dazu führen, dass die Spannung am Signaleingang des Steuergeräts stark einbricht. Das Steuergerät würde dann fehlerhaft eine Betätigung des Bedienelements erkennen.

Kurze Spannungsschwankungen werden in der Regel bereits durch die Entprellzeit verhindert, das heißt am Signaleingang des Steuergeräts muss das Betätigungssignal des Bedienelements für eine vorbestimmte Mindestsignaldauer, nämlich die Entprellzeit, anliegen, bevor das Steuergerät tatsächlich die Betätigung signalisiert. Die Entprellzeit gibt also vor, wie lange das Betätigungssignal mindestens anliegen muss, bevor das Steuergerät die Betätigung signalisiert. Je robuster der Signaleingang sein soll, desto größer wird die Entprellzeit gewählt. Um auch Spannungsschwankungen zu kompensieren, die beim Abklemmen oder Anklemmen der Batterie oder beim Betreiben des elektrischen Starters oder Anlassers für eine Brennkraftmaschine des Kraftfahrzeugs entstehen, muss eine unerwünscht hohe Entprellzeit eingestellt werden. Dann ist das System zwar sicher gegen solche Spannungsschwankungen, allerdings wird dadurch die Reaktionszeit groß. Wenn der Nutzer des Kraftfahrzeugs sehr kurz das Bedienelement betätigt, beispielsweise zu kurz auf einen Taster tippt, dann wird keine Betätigung erkannt, weil die Entprellzeit noch nicht abgelaufen ist, bevor das Betätigungssignal wieder beendet ist.

Aus der DE 44 32 955 A1 ist ein Verfahren zum Betreiben eines elektromotorischen Fensterscheibenhebers bekannt. Im Falle eines Resets, also der Wiedereinschaltung der elektrischen Spannung nach einem Spannungsausfall, erfolgt eine Wiederherstellung des Normalbetriebs erst dann, wenn der einzige Taster zum Bedienen des Fensterhebers mindestens dreimal betätigt wurde.

Aus der gattungsbildenden DE 10 2005 039 392 A1 ist ein Verfahren zur Sicherung von Systemvariablen bekannt. Im Fall einer Rücksetzung des Steuergeräts, das heißt eines Resets, wird durch Erkennen der bevorstehenden Rücksetzung eine Warnmeldung erzeugt und bei Erhalt der Warnmeldung die Systemvariablen aus einem flüchtigen Speicher ausgelesen und in einen nichtflüchtigen Speicher gespeichert.

Aus der DE 10 2011 085 437 A1 ist eine Schaltungsanordnung bekannt, mittels welcher eine Größe, die eine Spannung repräsentiert, dahingehend ausgewertet wird, dass ein Unterschreiten eines vorbestimmten Spannungsschwellwerts erkannt wird.

Der Erfindung liegt die Aufgabe zugrunde, die in einem Kraftfahrzeug möglichen Schwankungen der Versorgungsspannung dahingehend zu kompensieren, dass im Betrieb des Kraftfahrzeugs die Betätigung eines Bedienelements mit kurzer Entprellzeit erkannt werden kann.

Die Aufgabe wird durch die Gegenstände der unabhängigen Patentansprüche gelöst. Vorteilhafte Weiterbildungen der Erfindung sind durch die Merkmale der abhängigen Patentansprüche gegeben.

Die Erfindung umfasst ein Verfahren zum Erfassen einer Betätigung eines Bedienelements in einem Kraftfahrzeug. Bei dem Bedienelement kann es sich um ein mechanisches Bedienelement, beispielsweise einen Taster, handeln. Das Bedienelement erzeugt in Abhängigkeit von der Betätigung durch einen Benutzer ein Betätigungssignal. Das Betätigungssignal ist also nur vorhanden, während das Bedienelement tatsächlich betätigt wird. Ein Steuergerät empfängt das Betätigungssignal an einem Signaleingang. Das Steuergerät misst des Weiteren eine Signaldauer des Betätigungssignals und signalisiert die Betätigung dann, falls die Signaldauer größer als eine vorbestimmte Entprellzeit wird.

Um die Entprellzeit auf einen Entprellzeitwert einstellen zu können, bei dem man nicht darauf angewiesen ist, mittels der Entprellzeit einen Spannungseinbruch zu kompensieren, sieht die Erfindung nun folgende Weiterbildung vor. Durch das Steuergerät wird ein Betriebsparameter ermittelt und anhand des Betriebsparameters erkannt, dass eine an dem Steuergerät bereitgestellte Versorgungsspannung des Kraftfahrzeugs ein vorbestimmtes Instabilitätskriterium erfüllt. Mit anderen Worten überprüft das Steuergerät anhand des Betriebsparameters, ob die Versorgungsspannung in der Vergangenheit unter einen vorbestimmten Mindestwert gesunken ist. Unter dem Begriff "Vergangenheit" sind insbesondere die letzten 1000 Millisekunden oder 500 Millisekunden zu verstehen. Bei erfülltem Instabilitätskriterium, wenn also die Versorgungsspannung unter den Mindestwert gesunken war, wird das Messen der Signaldauer für eine vorbestimmte Sperrzeit verzögert. Mit anderen Worten wird ab Erkennen der Instabilität, wenn also das erfüllte Instabilitätskriterium erkannt wurde, zunächst das Betätigungssignal überhaupt nicht ausgewertet, bis die Sperrzeit vorbei ist. Beispielsweise kann an einem Signaleingang des Steuergeräts das Betätigungssignal für die Dauer der Sperrzeit einfach ignoriert werden. Die Sperrzeit weist bei erfülltem Instabilitätskriterium also einen Sperrzeitwert größer als 0 auf. Ist das Instabilitätskriterium dagegen nicht erfüllt, das heißt das Sperrzeitkriterium verletzt, ist der Sperrzeitwert gleich 0, das heißt ab Empfangen des Betätigungssignals wird die Signaldauer gemessen.

Durch die Erfindung ergibt sich der Vorteil, dass bei stabiler Versorgungsspannung, wenn das Instabilitätskriterium verletzt ist, nur die Entprellzeit zugrundegelegt wird, die zudem auf einen für die Bedienung optimierten Entprellzeitwert eingestellt werden kann, unabhängig von der Stabilität der Versorgungsspannung. Um eine Instabilität der Versorgungsspannung zu kompensieren, wird situationsabhängig die Sperrzeit verwendet. Hierdurch sind Entprellzeit und Instabilität der Versorgungsspannung voneinander entkoppelt.

Zu der Erfindung gehören auch Weiterbildungen, durch deren Merkmale sich zusätzliche Vorteile ergeben.

Der Betriebsparameter kann beispielsweise in einer einfachen Ausführungsform durch eine Energiemanagementeinrichtung des Bordnetzes des Kraftfahrzeugs bereitgestellt sein. Eine solche Energiemanagementeinrichtung kann beispielsweise einen zeitlichen Verlauf eines Betrags der Versorgungsspannung messen und eine Unterschreitung eines vorbestimmten Schwellwerts signalisieren.

Eine Weiterbildung kompensiert sogar einen besonders großen Spannungseinbruch, der einen Reset oder ein Zurücksetzen des Steuergeräts auslöst. Nach dem Reset startet das Steuergerät neu. Bei der Weiterbildung werden bei dem Neustart des Steuergeräts als Betriebsparameter Beschreibungsdaten des Neustarts ermittelt. Das Instabilitätskriterium umfasst entsprechend, dass die Beschreibungsdaten den Neustart signalisieren. Mit anderen Worten wird die Sperrzeit immer dann auf einen Sperrzeitwert größer 0 eingestellt, wenn das Steuergerät neu startet.

Eine Weiterbildung unterscheidet hierbei in vorteilhafter Weise zwischen den Ereignissen, durch welche ein Neustart verursacht werden kann. Bei dieser Weiterbildung wird für den Fall, dass die Beschreibungsdaten einen Watch-Dog-Reset angeben, ein erster Sperrzeitwert eingestellt. Ein Watch-Dog-Reset oder programmgesteuerter Reset wird durch eine Überwachungseinrichtung ausgelöst, die auch als Watch-Dog (Wachhund) bezeichnet wird.

Für den Fall, dass die Beschreibungsdaten einen durch einen Spannungsmangel verursachten Hard-Reset (schaltungstechnisch bedingter Reset) angeben, wird ein zweiter Sperrzeitwert eingestellt, der größer als der erste Sperrzeitwert ist. Da der Hard-Reset durch einen Spannungsmangel verursacht wird, ist es sehr wahrscheinlich, dass beim Neustart die Versorgungsspannung noch nicht ihren Nominalwert voll erreicht hat, sondern der Spannungswert kleiner als der Nominalwert ist. Bei einem Watch-Dog-Reset oder Watch-Dog-Reset wird die Auswertung des Bedienelements dagegen nur kürzer gesperrt, weil in diesem Fall keine Spannungsschwankungen im Kraftfahrzeug zu erwarten sind.

Gemäß einer Weiterbildung liegt der erste Sperrzeitwert in einem Bereich von 20 Millisekunden bis 70 Millisekunden. Gemäß einer Weiterbildung liegt der zweite Sperrzeitwert in einem Bereich von 100 Millisekunden bis 1 Sekunde. Hierdurch kann im Falle eines Hard-Resets eine Spannungsinstabilität zuverlässig überbrückt werden, wie sie in Kraftfahrzeugen typischerweise vorkommen kann. Durch den ersten Sperrzeitwert kann während des Neustarts die Auswertung des Bedienelements mit geringerer Verzögerung erfolgen.

Im normalen Betrieb bei stabiler Versorgungsspannung wird gemäß einer Weiterbildung ein Entprellzeitwert der Entprellzeit in einem Bereich von 20 Millisekunden bis 100 Millisekunden eingestellt. Ein solcher Entprellzeitwert eignet sich in vorteilhafter Weise zur Kompensation von Spannungsschwankungen, wie sie im Betrieb des Kraftfahrzeugs, wenn das Kraftfahrzeug beispielsweise fährt, vorkommen können und ermöglicht dennoch eine ausreichend schnelle Reaktion auf eine Betätigung des Bedienelements.

Gemäß einer Weiterbildung erzeugt das Bedienelement das Betätigungssignal, indem durch das Betätigen des Bedienelements ein Signaleingang des Steuergeräts mit einem Massepotential des Kraftfahrzeugs kurzgeschlossen wird. Hierdurch lässt sich das Bedienelement besonders kostengünstig und aufwandsarm ausgestalten.

Zu der Erfindung gehört auch das beschriebene Steuergerät zum Erfassen einer Betätigung eines Bedienelements. Das Steuergerät weist den beschriebenen Signaleingang zum Empfangen des Betätigungssignals des Bedienelements auf. Eine Steuereinrichtung ist dazu ausgelegt, eine Signaldauer des Betätigungselements zu messen und die Betätigung zu signalisieren, falls die Signaldauer größer als eine vorbestimmte Entprellzeit wird. Die Steuereinrichtung kann beispielsweise auf Grundlage eines Mikrocontrollers oder eines Mikroprozessors des Steuergeräts bereitgestellt sein. Das Steuergerät ist des Weiteren dazu ausgelegt, einen Betriebsparameter zu ermitteln und anhand des Betriebsparameters zu erkennen, dass eine Versorgungsspannung des Steuergeräts ein vorbestimmtes Instabilitätskriterium erfüllt. Als Betriebsparameter kann einer der bereits beschriebenen Betriebsparameter zugrunde gelegt sein.

Bei erfülltem Instabilitätskriterium wird durch das Steuergerät das Messen der Signaldauer für eine vorbestimmte Sperrzeit verzögert.

Zu der Erfindung gehören auch Weiterbildungen des erfindungsgemäßen Steuergeräts, die Merkmale aufweisen, wie sie bereits im Zusammenhang mit den Weiterbildungen des erfindungsgemäßen Verfahrens beschrieben worden sind. Aus diesem Grund sind die entsprechenden Weiterbildungen des erfindungsgemäßen Steuergeräts hier nicht noch einmal beschrieben.

Zu der Erfindung gehört auch ein Kraftfahrzeug mit einem Bedienelement und einer Ausführungsform des erfindungsgemäßen Steuergeräts, wobei das Bedienelement mit dem Signaleingang des Steuergeräts elektrisch verbunden ist. In dem erfindungsgemäßen Kraftfahrzeug kann das Bedienelement mit einer kleinen Entprellzeit ausgewertet werden, ohne dass es zu Fehlerkennungen der Betätigung, das heißt einem falschen Alarm, aufgrund einer instabilen Versorgungsspannung des Kraftfahrzeugs kommt.

Gemäß einer Weiterbildung des Kraftfahrzeugs ist das Bedienelement dazu ausgelegt, zum Erzeugen des Betätigungssignals den Signaleingang des Steuergeräts mit einem Massepotential kurzzuschließen.

Im Folgenden ist ein Ausführungsbeispiel der Erfindung beschrieben. Hierzu zeigt:
- Fig. 1: eine schematische Darstellung einer Ausführungsform des erfindungsgemäßen Kraftfahrzeugs, und
- Fig. 2: ein Flussschaudiagramm zu einer Ausführungsform des erfindungsgemäßen Verfahrens.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

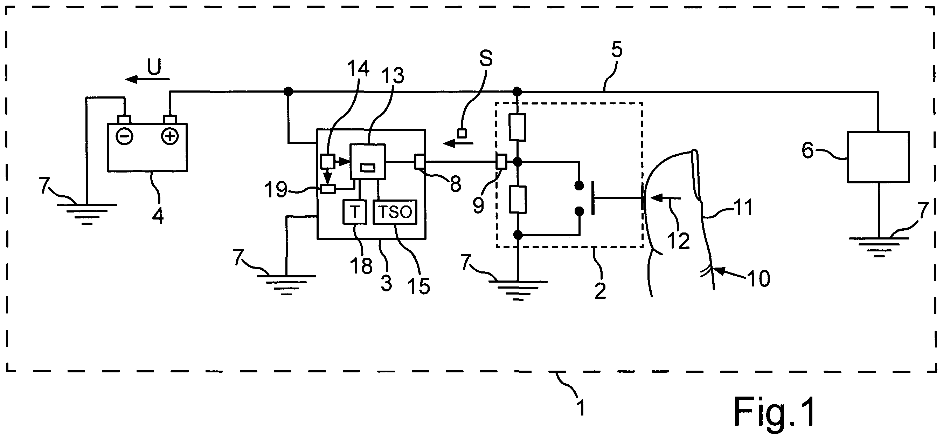

Fig. 1 zeigt ein Kraftfahrzeug 1, bei dem es sich beispielsweise um einen Kraftwagen, insbesondere einen Personenkraftwagen, handeln kann. Dargestellt sind ein Bedienelement 2, ein Steuergerät 3, eine Spannungsquelle 4, eine elektrische Bordnetzleitung 5, ein elektrischer Verbraucher 6 und ein Massepotential 7. Das Bedienelement 2 kann beispielsweise als ein Taster ausgestaltet sein, der beispielsweise in einem Fahrzeuginnenraum, beispielsweise in einem Armaturenbrett, angeordnet sein kann. Das Steuergerät 3 weist einen Steuereingang 8 auf, an welchen ein Signalausgang 9 des Bedienelements 2 angeschlossen ist. Die Spannungsquelle 4 kann beispielsweise eine Fahrzeugbatterie und/oder einen Generator des Kraftfahrzeugs bereitstellen. Die Spannungsquelle 4 erzeugt eine Versorgungsspannung U, die über die Bordnetzleitung 5 im Kraftfahrzeug 1 bereitgestellt wird. Der elektrische Verbraucher 6 kann an die Bordnetzleitung 5 angeschlossen sein. Der elektrische Verbraucher 6 kann beispielsweise ein elektrischer Starter oder Anlasser des Kraftfahrzeugs 1 sein. Über das Massepotential 7 können Stromkreise, die durch die Bordnetzleitung 5 gebildet sind, geschlossen werden. Das Massepotential 7 kann beispielsweise durch eine Masseleitung und/oder elektrisch leitende Bauteile des Kraftfahrzeugs, beispielsweise einen Fahrzeugrahmen, gebildet sein.

Das Bedienelement 2 und das Steuergerät 3 können ebenfalls mit der Bordnetzleitung 5 verbunden sein, um die Versorgungsspannung U zu empfangen. Das Bedienelement 2 kann durch einen Benutzer 10 bedient werden. Beispielsweise kann ein Benutzer 10 mit seinem Finger 11 eine Betätigung 12 des Bedienelements 2 durchführen, beispielsweise mit dem Finger 11 eine Taste des Bedienelements 2 betätigen oder drücken. Das Bedienelement 2 kann dazu ausgelegt sein, bei der Betätigung 12 den Signalausgang 9 mit dem Massepotential 7 kurzzuschließen, sodass auch der Signaleingang 8 des Steuergeräts 3 elektrisch mit dem Massepotential 6 verbunden oder kurzgeschlossen wird. Dies stellt ein Betätigungssignal S dar, welches von dem Signalausgang 9 an den Signaleingang 8 übertragen wird. Das Steuergerät 3 kann zum Erkennen des Steuersignals S eine Steuereinrichtung 13 aufweisen, bei der es sich beispielsweise um einen Mikrocontroller oder Mikroprozessor handeln kann.

Die Versorgungsspannung U der Spannungsquelle 4 kann schwanken. Beispielsweise kann bei einem Betrieb des Verbrauchers 6 die Versorgungsspannung U unter einen Nominalwert U0 sinken, der beispielsweise 12 Volt oder 48 Volt betragen kann. Während das Bedienelement 3 unbetätigt oder nicht-betätigt ist, sinkt auch die am Signaleingang 8 von dem Steuergerät 3 erfasste elektrische Spannung, sodass bei zu geringer elektrischer Spannung am Signaleingang 8 fälschlicherweise das Betätigungssignal S erkannt wird.

Des Weiteren kann durch das Absinken der Versorgungsspannung U unter einen Reset-Schwellenwert der Steuereinrichtung 13 ein Reset ausgelöst werden, nach welchem die Steuereinrichtung 13 einen Neustart durchführt. Mit anderen Worten startet das Steuergerät 3 neu. Beispielsweise beim Abklemmen oder Anklemmen der Bordnetzleitung 5 an die Spannungsquelle 4 kann es zu einer solchen Spannungsschwankung kommen.

Ein Reset der Steuereinrichtung 13 kann aber auch durch eine Watch-Dog-Einrichtung oder Überwachungseinrichtung 14 ausgelöst werden, also bei stabiler Versorgungsspannung U. Die Überwachungseinrichtung 14 kann den Reset beispielsweise auslösen, wenn erkannt wird, dass durch einen Programmfehler die Steuereinrichtung 13 beispielsweise in einer Endlosschleife wiederholt dieselben Befehle durchführt und hierdurch keine Überwachung des Signaleingangs 8 mehr erfolgt.

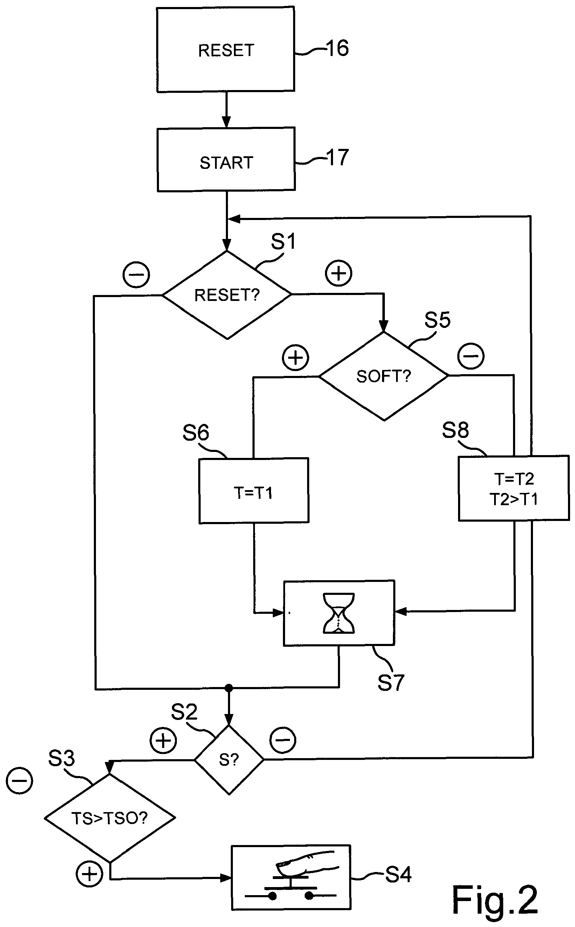

Um die Betätigung 12 trotz der beschriebenen Spannungsschwankungen und damit trotz der Einflüsse auf den Betrieb des Steuergeräts 3 zuverlässig mit einer vorbestimmten Entprellzeit 15 (TSO0) zu erkennen, kann die Steuereinrichtung 13 das im Folgenden anhand von Fig. 2 beschriebene Verfahren durchführen.

Mittels des Verfahrens kompensiert die Steuereinrichtung 13 den Einfluss eines Absinkens oder Spannungseinbruchs der Versorgungsspannung U, durch welchen ein Reset der Steuereinrichtung 13 verursacht wurde. Dagegen wird bei stabiler Versorgungsspannung U und einem Neustart, der durch einen Watch-Dog-Reset der Überwachungseinrichtung 14 ausgelöst wurde, keine unnötige Verzögerung bei der Erkennung der Betätigung 12 verursacht.

Zur Erläuterung der Funktionsweise der Steuereinrichtung 13 wird davon ausgegangen, dass es aus einem für die Steuereinrichtung 13 zunächst unbekannten Grund zu einem Reset 16 kommt, woraufhin die Steuereinrichtung 13 bei ausreichend großer Versorgungsspannung U (größer als der Reset-Schwellenwert) einen Neustart 17 durchführt.

In einem Schritt S1 überprüft die Steuereinrichtung 13, ob sie gerade einen Neustart durchführt oder der Neustart bereits abgeschlossen ist. Bei abgeschlossenem Neustart (in Fig. 2 durch ein Minus-Zeichen "-" symbolisiert), überprüft die Steuereinrichtung 13 in einem Schritt S2, ob am Signaleingang 8 das Betätigungssignal 8 anliegt. Falls kein Betätigungssignal S anliegt (Minus-Zeichen "-"), wird wieder im Schritt S1 überprüft, ob sich die Steuereinrichtung 13 gerade in einem Neustart befindet. Wird im Schritt S2 am Signaleingang 8 das Betätigungssignal S erkannt (Plus-Zeichen "+"), so wird in einem Schritt S3 überprüft, ob das Betätigungssignal S länger als die Entprellzeit 15 (TSO) anliegt. Hierzu wird ab Empfangen des Betätigungssignals S eine Signaldauer TS gemessen. Falls die Signaldauer TS größer als die Entprellzeit TS0 wird (Plus-Zeichen "+"), wird in einem Schritt S4 die Betätigung 12 des Bedienelements 2 signalisiert. Beispielsweise kann dann in Abhängigkeit von der Signalisierung der Betätigung 12 eine Fahrzeugfunktion in dem Kraftfahrzeug 1 ausgelöst werden. Beispielsweise können das Bedienelement 2 und das Steuergerät 3 Bestandteil eines Informations-Unterhaltungssystems (Infotainmentsystems) des Kraftfahrzeugs 1 sein. Als Fahrzeugfunktion kann dann beispielsweise das Aktivieren eines Telefons oder eines Radios oder eines Navigationsgeräts erfolgen. Als Fahrzeugfunktion kann auch beispielsweise eine Bestätigungstaste (OK-Taste) oder eine Pfeil-Taste erkannt werden und eine entsprechende Steuerung beispielsweise in einem Bedienmenü durchgeführt werden.

Falls im Schritt S3 die Signaldauer TS kleiner als die Entprellzeit TS0 ist und das Betätigungssignal S beendet ist (Minus-Zeichen "-" im Schritt S3), so überprüft die Signaleinrichtung 13 wieder im Schritt S1, ob sich die Steuereinrichtung 13 in der Neustart-Routine befindet.

Wird im Schritt S1 erkannt, dass gerade der Neustart durchgeführt wird (Plus-Zeichen "+"), so wird in einem Schritt S5 überprüft, ob der Neustart 17 durch einen Watch-Dog-Reset der Überwachungseinrichtung 14 ausgelöst wurde. Bei einem Watch-Dog-Reset (Plus-Zeichen "+") wird in einem Schritt S6 eine Sperrzeit 18 (T) auf einen ersten Sperrzeitwert T1 eingestellt. Anschließend wird in einem Schritt S7 die Auswertung des Signaleingangs 8 gesperrt, das heißt die Steuereinrichtung 13 wartet für die Sperrzeit T, bevor in dem Schritt S2 überprüft wird, ob das Betätigungssignal S am Signaleingang 8 vorliegt.

Falls in dem Schritt S5 erkannt wird, dass kein Watch-Dog-Reset, sondern ein Hard-Reset z.B. aufgrund eines Absinkens der Versorgungsspannung U unter den Reset-Schwellenwert von beispielsweise 5 Volt oder 5,5 Volt folgt (Minus-Zeichen "-"), so wird in einem Schritt S8 die Sperrzeit T auf einen zweiten Sperrzeitwert T2 eingestellt, der größer als der erste Sperrzeitwert T1 ist. Anschließend wird in dem Schritt S7 die Auswertung des Signaleingangs 8 für die Sperrzeit T verzögert.

Durch das Verfahren ist das Steuergerät robust gegenüber einer Spannungsschwankung der Versorgungsspannung U und im Normalbetrieb bei stabiler Versorgungsspannung reaktionsschnell bei der Betätigung 12 des Bedienelement 2. Zur Betätigung/Auswertung des Betätigungssignals S wird eine Entprellzeit eingestellt, die in einem Bereich von 20 Millisekunden bis 100 Millisekunden liegt. Hierdurch ist der Bedienkomfort so hoch wie bei gewöhnlichen Steuergeräten. Des Weiteren beobachtet das Steuergerät die Umgebungsbedingungen, indem es erkennt, ob ein Reset vorliegt. In Abhängigkeit von zwei Reset-Gründen wird die Auswertung des Bedienelements 2, das heißt des Betätigungssignals S, gesperrt.

Es wird hierzu überwacht, ob das Steuergerät durch einen Reset geht (Schritt S1). Darüber hinaus wird ausgewertet, welche Art von Reset den Neustart ausgelöst hat. Die hierzu verwendeten Beschreibungsdaten, die angeben, welche Ursache (Watch-Dog-Reset oder Hard-Reset) der Neustart hat, können als Betriebsparameter 19 in dem Steuergerät 3 bereitgestellt werden. Das Bereitstellen dieser Beschreibungsdaten ist an sich aus dem Stand der Technik bekannt.

Es werden zwei Reset-Gründe bewertet, nämlich als Grund 1, ob ein Watch-Dog-Reset, zum Beispiel ein Software-Reset, oder als Grund 2 ein Hard-Reset, beispielsweise durch das Abklemmen der Spannungsquelle 4, vorliegt.

Je nachdem, welcher Reset-Grund erkannt wird, wird die Auswertung des Bedienelements für eine bestimmte Zeit gesperrt oder nicht. Bei einem Watch-Dog-Reset wird die Auswertung des Tasters nur sehr kurz gesperrt, beispielsweise für 30 Millisekunden, weil in diesem Fall keine Spannungsschwankungen im Fahrzeug zu erwarten sind. Der Reset war Steuergerätspezifisch und nicht durch eine Spannungsschwankung verursacht. Bei einem Hard-Reset wird die Auswertung des Bedienelements 2 für eine längere Zeit gesperrt, beispielsweise für 100 Millisekunden, weil Spannungsschwankungen im Fahrzeug zu erwarten sind, die zu Fehlauslösungen führen können.

Nach Ablauf der Sperrzeit T, die beispielsweise 100 Millisekunden betragen kann, kann das Bedienelement 2 wieder mit der eingestellten Entprellzeit ausgewertet werden. Die eingestellte Entprellzeit kann in diesem Fall sehr gering sein, beispielsweise bei 40 Millisekunden liegen. Dadurch sind der Bedienkomfort und die Reaktionsgeschwindigkeit des Steuergeräts 3 im normalen Betrieb sehr hoch, sodass auch sehr kurze Betätigungen 12 des Bedienelements 2, insbesondere eines Tasters, erkannt werden können.

Insgesamt zeigt das Beispiel, wie durch die Erfindung ein Verfahren zur Auswertung eines Tasters bereitgestellt wird.

## Patentansprüche

1. Verfahren zum Erfassen einer Betätigung (12) eines Bedienelements (2) in einem Kraftfahrzeug (1), wobei das Bedienelement (2) in Abhängigkeit von der Betätigung (12) ein Betätigungssignal (S) erzeugt und ein Steuergerät (3) das Betätigungssignal (S) empfängt (S2) und eine Signaldauer (TS) des Betätigungssignals (S) misst (S3) und die Betätigung (12) signalisiert (S4), falls die Signaldauer (TS) größer als eine vorbestimmte Entprellzeit (TSO) wird,
**dadurch gekennzeichnet, dass**
durch das Steuergerät (3) ein Betriebsparameter (19) ermittelt wird und anhand des Betriebsparameters (19) erkannt wird (S1), dass eine an dem Steuergerät (3) bereitgestellte Versorgungsspannung (U) des Kraftfahrzeugs (1) ein vorbestimmtes Instabilitätskriterium erfüllt, und bei erfülltem Instabilitätskriterium das Messen (S2) der Signaldauer (TS) für eine vorbestimmten Sperrzeit (T) verzögert wird.

2. Verfahren nach Anspruch 1, wobei bei einem Neustart (17) des Steuergeräts (3) als Betriebsparameter (19) Beschreibungsdaten des Neustarts (17) ermittelt werden und das Instabilitätskriterium umfasst, dass die Beschreibungsdaten den Neustart (17) signalisieren.

3. Verfahren nach Anspruch 2, wobei für den Fall, dass die Beschreibungsdaten einen durch eine Überwachungseinrichtung (14) ausgelösten Watch-Dog-Reset angeben, ein erster Sperrzeitwert (T1) und für den Fall, dass die Beschreibungsdaten einen durch einen Spannungsmangel verursachten Hard-Reset angeben, ein zweiter Sperrzeitwert (T2), der größer als der erste Sperrzeitwert (T1) ist, eingestellt wird.

4. Verfahren nach Anspruch 3, wobei der erste Sperrzeitwert (T1) in einem Bereich von 20 Millisekunden bis 70 Millisekunden und/oder der zweite Sperrzeitwert (T2) in einem Bereich von 100 Millisekunden bis 1 Sekunde liegt.

5. Verfahren nach einem der vorhergehenden Ansprüche, wobei ein Entprellzeitwert der Entprellzeit (TSO) in einem Bereich von 20 Millisekunden bis 100 Millisekunden liegt.

6. Verfahren nach einem der vorhergehenden Ansprüche, wobei das Bedienelement (2) das Betätigungssignal (S) erzeugt, indem durch das Betätigen (12) des Bedienelements (2) ein Signaleingang (8) des Steuergeräts (3) mit einem Massepotential (7) des Kraftfahrzeugs (1) kurzgeschlossen wird.

7. Steuergerät (3) zum Erfassen einer Betätigung (12) eines Bedienelements (2), aufweisend:
- einen Signaleingang (8) zum Empfangen eines Betätigungssignals (S) des Bedienelements (2) und
- eine Steuereinrichtung (3), die dazu ausgelegt ist, eine Signaldauer (TS) des Betätigungssignals (S) zu messen (S3) und die Betätigung (12) zu signalisieren (S4), falls die Signaldauer (TS) größer als eine vorbestimmte Entprellzeit (TS) wird,
**dadurch gekennzeichnet, dass**
das Steuergerät (3) dazu ausgelegt ist, einen Betriebsparameter (19) zu ermitteln und anhand des Betriebsparameters (19) zu erkennen (S1), dass eine Versorgungsspannung (U) des Steuergeräts (3) ein vorbestimmtes Instabilitätskriterium erfüllt, und bei erfülltem Instabilitätskriterium das Messen der Signaldauer (TS) für eine vorbestimmten Sperrzeit (T) zu verzögern.

8. Kraftfahrzeug (1) mit einem Bedienelement (2) und einem Steuergerät (3) nach Anspruch 7, wobei das Bedienelement (2) mit dem Signaleingang (8) des Steuergeräts (3) elektrisch verbunden ist.

9. Kraftfahrzeug (1) nach Anspruch 8, wobei das Bedienelement (2) dazu ausgelegt ist, zum Erzeugen des Betätigungssignals (S) den Signaleingang (8) des Steuergeräts (3) mit einem Massepotential (7) des Kraftfahrzeugs (1) kurzzuschließen.

## Claims

1. Method for detecting an activation (12) of an operator control element (2) in a motor vehicle (1), wherein the operator control element (2) depending on the activation (12) generates an activation signal (S) and a control device (3) receives (S2) the activation signal (S) and measures (S3) a signal duration (TS) of the activation signal (S) and signals (S4) the activation (12) in the case that the signal duration (TS) is greater than a predetermined debounce time (TS0),
**characterised in that**
via the control device (3) is detected an operating parameter (19) and with the aid of the operating parameter (19) it is recognised (S1) that a supply voltage (U), provided at the control device (3), of the motor vehicle (1) fulfils a predetermined instability criterion, and in the case of a fulfilled instability criterion the measuring (S2) of the signal duration (TS) is delayed for a predetermined blocking time (T).

2. Method according to claim 1, wherein at a new start (17) of the control device (3) as operating parameter (19) description data of the new start (17) are detected and the instability criterion includes that the description data signal the new start (17).

3. Method according to claim 2, wherein in the case that the description data specify a watch-dog-reset triggered by a monitoring device (14), a first blocking time value (T1) is set, and in the case that the description data specify a hard-reset caused by a lack of voltage, a second blocking time value (T2), which is greater than the first blocking time value (T1), is set.

4. Method according to claim 3, wherein the first blocking time value (T1) is in a range between 20 milliseconds to 70 milliseconds and/or the second blocking time value (T2) is in a range of 100 milliseconds to 1 second.

5. Method according to any of the preceding claims, wherein a debounce time value for the debounce time (TS0) is in a range of between 20 milliseconds to 100 milliseconds.

6. Method according to any of the preceding claims, wherein the operator control element (2) generates the activation signal (S), in that by means of the activation (12) of the operator control element (2) a signal input (8) of the control device (3) is shortcircuited with an earth potential (7) of the motor vehicle (1).

7. Control device (3) for the detection of an activation (12) of an operator control element (2), having:
- a signal input (8) for the reception of an activation signal (S) of the operator control element (2), and
- a control device (3) which is configured to measure (S3) a signal duration (TS) of the activation signal (S) and to signal (S4) the activation (12), in the case that the signal duration (TS) becomes greater than a predetermined debounce time (TS),
**characterised in that**
the control device (3) is configured to detect an operating parameter (19) and with the aid of the operating parameter (19) to recognise (S1) that a supply voltage (U) of the control device (3) fulfils a predetermined instability criterion, and in the case of a fulfilled instability criterion to delay the measuring of the signal duration (TS) for a predetermined blocking time (T).

8. Motor vehicle (1) having an operator control element (2) and a control device (3) according to claim 7, wherein the operator control element (2) is electrically connected with the signal input (8) of the control device (3).

9. Motor vehicle (1) according to claim 8, wherein the operator control element (2) is configured, for the generation of the activation signal (S), to short-circuit the signal input (8) of the control device (3) with an earth potential (7) of the motor vehicle (1).

## Revendications

1. Procédé de détection d'un actionnement (12) d'un élément de commande (2) dans un véhicule automobile (1), dans lequel l'élément de commande (2) produit un signal d'actionnement (S) en fonction de l'actionnement (12) et un appareil de commande (3) reçoit (S2) le signal d'actionnement (S) et mesure (S3) une durée de signal (TS) du signal d'actionnement (S) et signale (S4) l'actionnement (12) si la durée de signal (TS) est supérieure à un temps de stabilisation (TS0) prédéterminé,
**caractérisé en ce que**, au moyen de l'appareil de commande (3), on détermine un paramètre de fonctionnement (19) et on détecte (S1) à l'aide du paramètre de fonctionnement (19) si une tension d'alimentation (U), fournie au niveau de l'appareil de commande (3), du véhicule automobile (1) satisfait un critère d'instabilité prédéterminé et, si le critère d'instabilité est satisfait, on retarde la mesure (S2) de la durée de signal (TS) pendant un temps de blocage (T) prédéterminé.

2. Procédé selon la revendication 1, dans lequel, lors d'un redémarrage (17) de l'appareil de commande (3), des données de description du redémarrage (17) sont déterminées comme paramètres de fonctionnement (19) et le critère d'instabilité comprend le fait que les données de description signalent le redémarrage (17).

3. Procédé selon la revendication 2, dans lequel une première valeur temporelle de blocage (T1) est réglée si les données de description indiquent une réinitialisation de chien de garde déclenchée par un dispositif de surveillance (14) et une seconde valeur temporelle de blocage (T2), qui est supérieure à la première valeur temporelle de blocage (T1), est réglée si les données de description indiquent une réinitialisation matérielle provoquée par un défaut de tension.

4. Procédé selon la revendication 3, dans lequel la première valeur temporelle de blocage (T1) est comprise dans une plage allant de 20 millisecondes à 70 millisecondes et/ou la seconde valeur temporelle de blocage (T2) est comprise dans une plage allant de 100 millisecondes à 1 seconde.

5. Procédé selon l'une quelconque des revendications précédentes, dans lequel une valeur temporelle de stabilisation du temps de stabilisation (TS0) est comprise dans une plage allant de 20 millisecondes à 100 millisecondes.

6. Procédé selon l'une quelconque des revendications précédentes, dans lequel l'élément de commande (2) produit le signal d'actionnement (S) du fait que, par l'actionnement (12) de l'élément de commande (2), une entrée de signal (8) de l'appareil de commande (3) est court-circuitée avec un potentiel de masse (7) du véhicule automobile (1).

7. Appareil de commande (3) pour la détection d'un actionnement (12) d'un élément de commande (2), comportant :
- une entrée de signal (8) destinée à la réception d'un signal d'actionnement (S) de l'élément de commande (2) et
- un dispositif de commande (3) qui est conçu pour mesurer (S3) une durée de signal (TS) du signal d'actionnement (S) et pour signaler (S4) l'actionnement (12) si la durée de signal (S) est supérieure à un temps de stabilisation (TS) prédéterminé,
**caractérisé en ce que** l'appareil de commande (3) est conçu pour déterminer un paramètre de fonctionnement (19) et pour détecter (S1) à l'aide du paramètre de fonctionnement (19) si une tension d'alimentation (U) de l'appareil de commande (3) satisfait un critère d'instabilité prédéterminé et, si le critère d'instabilité est satisfait, pour retarder la mesure de la durée de signal (TS) pendant un temps de blocage prédéterminé (T).

8. Véhicule automobile (1) avec un élément de commande (2) et avec un appareil de commande (3) selon la revendication 7, dans lequel l'élément de commande (2) est relié électriquement à l'entrée de signal (8) de l'appareil de commande (3).

9. Véhicule automobile (1) selon la revendication 8, dans lequel l'élément de commande (2) est conçu pour, dans le but de produire le signal d'actionnement (S), court-circuiter l'entrée de signal (8) de l'appareil de commande (3) avec un potentiel de masse (7) du véhicule automobile (1).
